# EUROPÄISCHE PATENTSCHRIFT

(11) **EP 0 559 945 B1**
(45) Veröffentlichungstag und Bekanntmachung des Hinweises auf die Patenterteilung: **16.10.1996**
(21) Anmeldenummer: 92104375.8
(22) Anmeldetag: 13.03.1992
(51) Int. Cl.: H01L 29/74

(54) **Abschaltbares Leistungshalbleiter-Bauelement**
Turn-off power semi-conductor device
Dispositif semi-conducteur de puissance à extinction

(43) Veröffentlichungstag der Anmeldung: 15.09.1993
(73) Patentinhaber: ASEA BROWN BOVERI AG, CH-5401 Baden (CH)
(72) Erfinder: Bauer, Friedhelm, Dr., CH-3063 Ittigen (CH)

(56) Entgegenhaltungen:
- EP-A- 0 270 975
- EP-A- 0 340 445
- EP-A- 0 424 710
- ELEKTRONIK Bd. 39, Nr. 18, 31. August 1990, München DE, Seite 52, XP151517; R. JACOBSEN : 'Leistungsstarke BIMOS-Bausteine in Sicht'

## Beschreibung

### TECHNISCHES GEBIET

Die vorliegende Erfindung bezieht sich auf das Gebiet der Leistungselektronik. Sie betrifft ein abschaltbares Leistungshalbleiter-Bauelement nach dem Oberbegriff des ersten Anspruchs.

Ein solches Bauelement ist z.B. aus der Druckschrift EP-A1-0 340 445 bekannt.

### STAND DER TECHNIK

Es ist beim heutigen Stand der Technik denkbar, dass MOS-kontrollierte Thyristoren (MCTs) leistungsmässig nicht nur in die Lücke zwischen herkömmlichen Gate-Turn-Off-Thyristoren (GTOs) und Insulated-Gate-Bipolar-Transistoren (IGBTs) stossen, sondern sogar in Anwendungsbereiche der beiden Schaltertypen eindringen.

Mit der konventionellen MCT-Struktur können bereits Anodenspannungen von 3,5 kV blockiert werden. Bauelemente mit einer aktiven Fläche von 0,5 cm² können etwa 40 A Anodenstrom schalten. Wegen der Thyristornatur des MCT werden dabei Durchlassspannungen erreicht, welche typisch für 4-Schicht-Halbleiterstrukturen sind. Allerdings leidet der MCT wie jeder Thyristor unter der Problematik der inhomogenen Stromdichteverteilungen während des Abschaltens; daraus folgt eine Skalierung des maximal abschaltbaren Stroms mit der Grösse der aktiven Fläche, die wesentlich hinter einer linearen Skalierung zurückbleibt.

Auf der anderen Seite sind IGBTs heute die Schalter der Wahl für Anwendungen mit maximalen Blockierspannungen von 1200 bis 1400 V. Die Entwicklung und Kommerzialisierung von IGBTs mit noch höheren Blockierspannungen ist allerdings mit erheblichem Aufwand an Zeit und Kosten verbunden. Wegen seiner Transistornatur wäre der IGBT für sehr hohe Blockierspannungen zwar machbar, aber dem Betrieb wären wegen der exzessiven Leistungsverluste Grenzen gesetzt.

Gleichwohl besitzt der IGBT als Bauelement aus folgenden Gründen eine grosse Attraktivität:
(1) Stabiles Abschalten: Es treten keine Strominhomogenitäten auf und der abschaltbare Strom skaliert linear mit der aktiven Fläche; für das Abschalten sind in der Regel keine Schutzbeschaltungen notwendig.
(2) Strombegrenzung: Wegen der Transistorcharakteristik sättigt der Kollektorstrom I_{C} bei fester Gatespannung auch bei den höchsten erlaubten Werten der Kollektor-Emitter-Spannung V_{CE}. Das Bauelement ist also kurzschlussfest und fehlertolerant, falls dieser Fehler in kurzer Zeit (typ. 10 µs) behoben werden, d.h., falls abgeschaltet werden kann. Diese Eigenschaft ist für einige Anwendungen von fundamentaler Wichtigkeit. Weiter ist die Eigenschaft der Strombegrenzung Voraussetzung für ein unproblematisches Parallelschalten von mehreren Bauelementen.
(3) Dynamische Verluste: Zur Leitung des Stroms setzt der IGBT weniger Ladungsträgerplasma ein als ein Thyristor (dies ist der Grund für seine vergleichsweise hohen Durchlassverluste). Andererseits ist die geringere Ladung schneller ausgeräumt. Damit sind die Schaltverluste (insbesondere die relativ hohen Ausschaltverluste) wesentlich kleiner als bei einer vergleichbaren Thyristorstruktur.

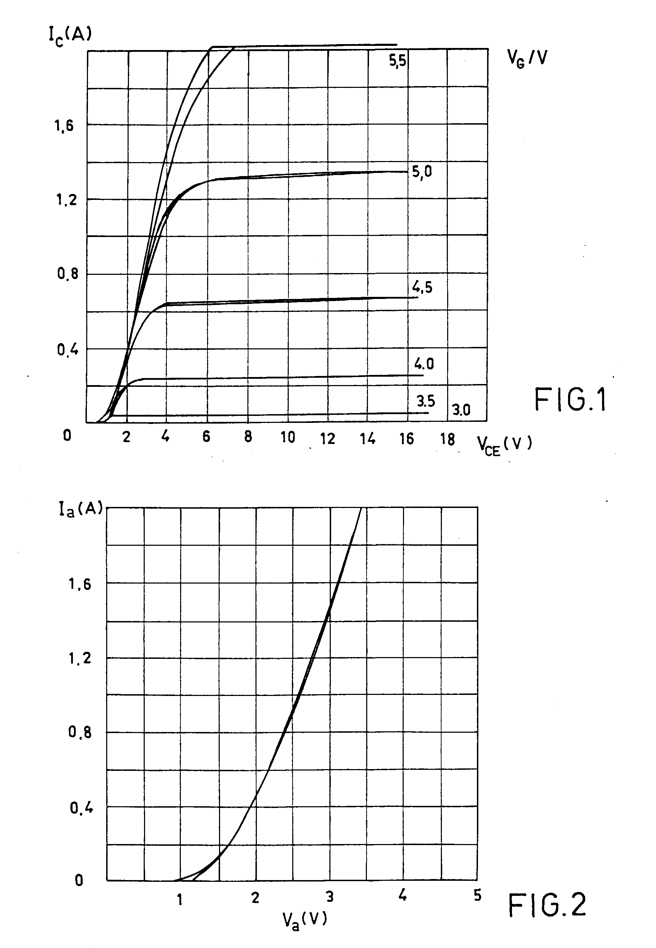

Zum direkten experimentellen Vergleich beider Strukturen (MCT und IGBT) sind entsprechende Testbauelemente mit einer aktiven Fläche von jeweils etwa 1,6 mm² auf einem Si-lizium-Wafer (gleiche Substratdicke, gleicher Randabschluss, identische Trägerlebensdauereinstellung) hergestellt und durchgemessen worden. Der IGBT ist dabei zweckmässigerweise aus Streifen aufgebaut, während der MCT aus bekannten Gründen eine grosse Anzahl von Elementarzellen umfasst. Die Ergebnisse dieser Messungen sind in den Figuren 1 bis 4 wiedergegeben.

Die Figuren 1 und 2 zeigen die statischen Charakteristiken der beiden Bauelemente. Im Falle des IGBT (Fig. 1; Kollektorstrom I_{C} über der Kollektor-Emitter-Spannung V_{CE} in Abhängigkeit von der Gatespannung V_{G} als Parameter) handelt es sich um ein unbestrahltes Bauelement, der MCT (Fig. 2; Anodenstrom Iₐ über der Anoden-Vorwärtsspannung Vₐ) hat eine Elektronenbestrahlung mit einer Dosis von 5^{*}10¹³ cm⁻² erhalten.

Bei einer Stromdichte von 100 A/cm², welcher ein Strom von 1,6 A entspricht, beträgt die Anoden-Vorwärtsspannung des bestrahlten MCT etwa 3,1 V (Fig. 2). Der nicht bestrahlte IGBT erzielt diese Stromdichte bei einer Kollektor-Emitter-Spannung von etwa 5 V (Fig. 1). Ein mit gleicher Dosis wie der MCT bestrahlter IGBT würde diese Stromdichte sogar erst bei einer Spannung von mehr als 9 V erreichen und würde daher im praktischen Betrieb hohe Durchlassverluste verursachen. Bei typischen Durchlassspannungen von 4 V kann der IGBT dagegen nur einen Strom von 0,4 A leiten. Hieraus wird deutlich, dass die notwendige Siliziumfläche für einen gegebenen Strom im Falle des IGBT bis zu viermal grösser sein muss als beim vergleichbaren MCT. Bei der Betrachtung dieser hohen Durchlassspannungen muss allerdings berücksichtigt werden, dass der IGBT in diesem Vergleich für eine Blockierspannung von 3,5 kV ausgelegt ist.

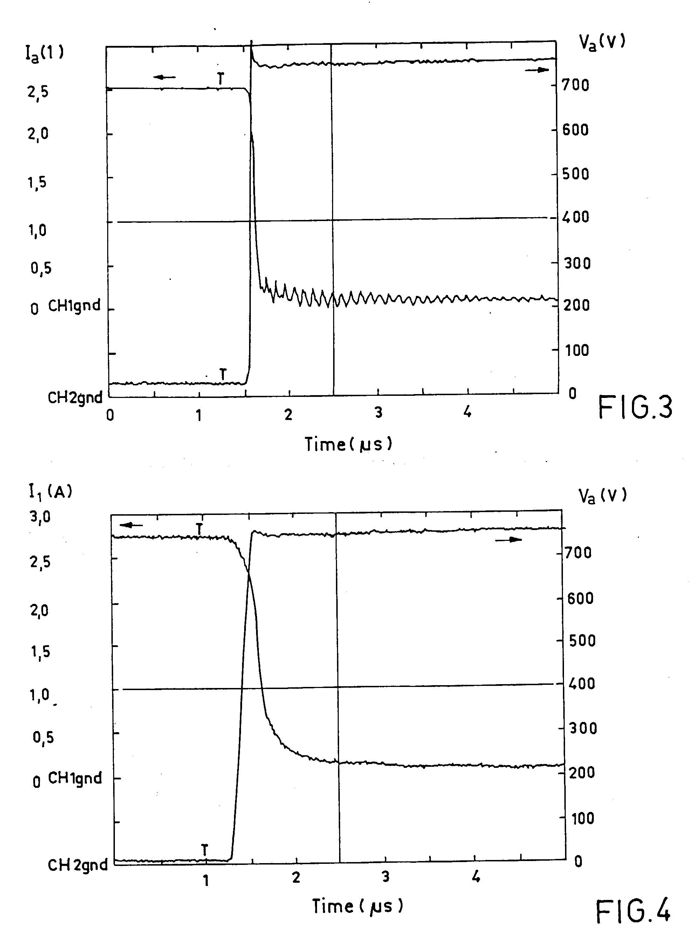

Der Vergleich der beiden Bauelemente bezuglich des Abschaltverhaltens fällt nun zugunsten des IGBT aus. Fig. 3 (IGBT) und Fig. 4 (MCT) zeigen jeweils den zeitlichen Verlauf von Anodenstrom Iₐ (etwa 2,5 A) und Anodenspannung Vₐ (Klemmenspannung 700 V), wobei der eigentliche Ausschaltzeitpunkt jeweils mit einem T gekennzeichnet ist. Im Fall des MCT ist der Stromwert von 2,75 A der maximal abschaltbare Strom. Der IGBT dagegen ist mit 2,5 A nur durch den speziellen Messaufbau begrenzt, da die im Aufbau verwendete Spule nur eine begrenzte Energiemenge zur Verfügung stellen kann. Der Zeitmasstab in den Figuren 3 und 4 ist identisch; es wird deutlich, dass der IGBT wegen seiner geringen Plasmadichte sehr viel schneller und mit erheblich geringeren Verlusten abschalten kann.

Die oben gegebenen Erläuterungen machen deutlich, dass es wünschenswert wäre, ein Bauelement zu schaffen, welches die beschriebenen guten Eigenschaften des IGBT (hinsichtlich des Abschaltverhaltens) und des MCT (hinsichtlich des Durchlassverhaltens) in sich vereint.

In der eingangs genannten Druckschrift ist bereits ein MOS-kontrolliertes Bauelement vorgeschlagen worden, welches in einem gemeinsamen Substrat nebeneinander in elektrischer Parallelschaltung sowohl MCT- wie auch IGBT-Zellen aufweist. Die IGBT-Zellen sind dabei hauptsächlich als sehr effektive, MOS-kontrollierte Einschaltzellen vorgesehen und werden daher zusammen mit den MCT-Zellen über eine gemeinsame Gateelektrode angesteuert. Obgleich die IGBT-Zellen die MCT-Zellen auch beim Abschalten unterstützen, kommen wegen der gemeinsamen Ansteuerung die spezifischen Vorteile der IGBT-Struktur nicht hinreichend zur Geltung.

Aus einem Artikel von R. Jacobsen in Elektronik Bd. 39 No. 18 ist ausserdem eine Leistungshalbleiterbauelement mit getrennten MCT und IGBT Zellen bekannt. Jeder der Zelltypen weist eine eigene Gateelektrode auf. Die Gateelektroden werden mit an die entsprechenden Gateanschlüsse angelegten unterschiedlichen Gatesignalen angesteuert.

Nachteilig bei einer Anordnung mit getrennten Gateanschlüssen ist jedoch, dass die Kontaktierung in einem Gehäuse schwierig und platzbeanspruchend ist.

### DARSTELLUNG DER ERFINDUNG

Es ist daher Aufgabe der vorliegenden Erfindung, ein Bauelement der eingangs genannten Art dahingehend zu verbessern, dass die Kontaktierung der Gateanschlüsse möglichst einfach vollzogen werden kann.

Die Aufgabe wird bei einem Bauelement der eingangs genannten Art durch die Merkmale des ersten Anspruchs gelöst.

Der Kern der Erfindung besteht also darin, dass zwischen den Gateelektroden ein Laufzeitglied vorgesehen ist. Auf diese Weise muss nur ein einziger Gateanschluss kontaktiert werden.

In einem bevorzugten Ausführungsbeispiel wird das Laufzeitglied durch ein hochohmiges Zwischengebiet, insbesondere aus undotiertem Polysilizium gebildet.

Mit der Bauelementstruktur nach der Erfindung ergeben sich die folgenden Vorteile:
(1) Niedrige Durchlassverluste (wie bei einem MCT)
(2) Niedrige Schaltverluste (wie bei einem IGBT)
(3) Ein Abschalten als IGBT, also
   - Fähigkeit zur Stromsättigung in der Abschaltphase, d.h. Kurzschlussfestigkeit
   - keine Stromfilamentierung während des Abschaltens, also lineare Skalierung des abschaltbaren Stromes mit der aktiven Fläche
   - einfaches Parallelschalten mehrerer Chips
   - integrierte Stromsensoren können das Bauelement in der Strombalance halten (intelligent switch)
(4) In Kombination der Eigenschaften von MCT und IGBT
   - konkurrenzlos kleine Totalverluste
   - extrem hohe abschaltbare Anodenströme (selbst Stossströme von mehr als 500 A/cm² sind kurzfristig vom IGBT beherrschbar).
Weitere Ausführungsformene ergeben sich aus den abhängigen Ansprüchen.

### KURZE BESCHREIBUNG DER ZEICHNUNG

Die Erfindung soll nachfolgend anhand von Ausführungsbeispielen im Zusammenhang mit der Zeichnung näher erläutert werden. Es zeigen
- Fig. 5: im Querschnitt ein Bauelement wichtig für das Verständnis der Erfindung mit vollständig getrennten Gateelektroden für die MCT- und IGBT-Zellen;
- Fig. 6: eine von der Kathodenfläche her gesehene mögliche Anordnung der MCT- und IGBT-Zellen aus Fig. 5 in Form einer ineinandergreifenden Fingerstruktur mit getrennten Gatekontakten; und
- Fig. 7: im Querschnitt ein zweites bevorzugtes Ausführungsbeispiel des Bauelements nach der Erfindung mit über ein Zwischengebiet in Verbindung stehenden Gateelektroden für die MCT- und IGBT-Zellen.

### WEGE ZUR AUSFÜHRUNG DER ERFINDUNG

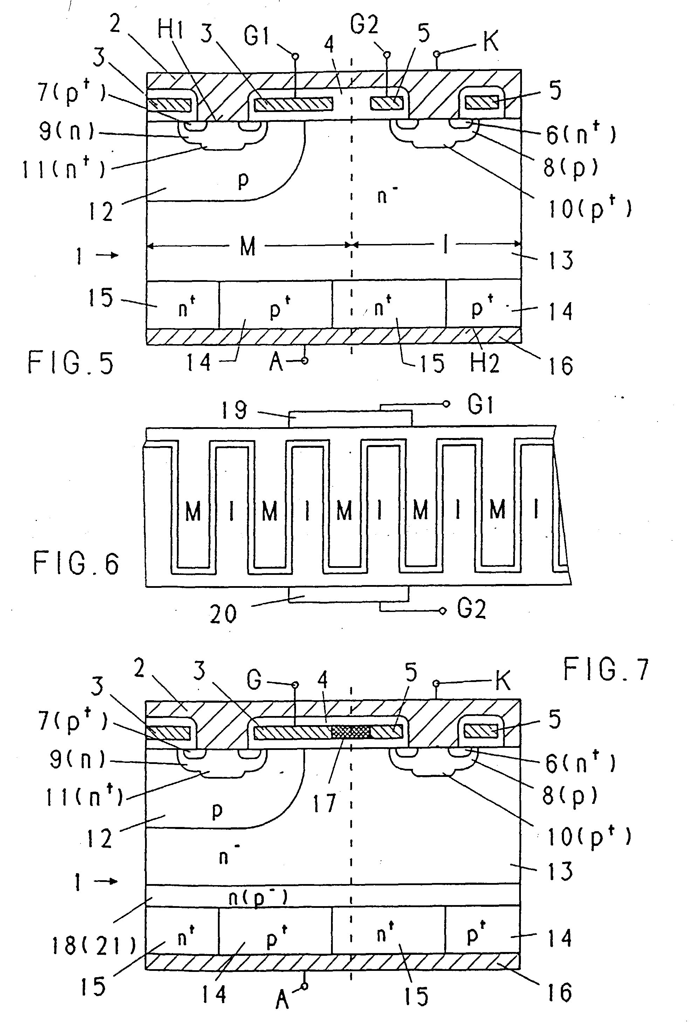

In Fig. 5 ist ein Bauelements wichtig für das Verständnis der Erfindung ausschnittweise (für zwei Zellen) im Querschnitt dargestellt.

In einem Halbleitersubstrat 1, welches durch zwei gegenüberliegende Hauptflächen H1 und H2 begrenzt wird, die einer Kathode K bzw. einer Anode A zugeordnet sind, ist eine Schichtenfolge aus einer anodenseitigen Emitterschicht 14 von einem ersten Leitfähigkeitstyp (hier: p⁺-dotiert) und einer darüberliegenden ersten Basisschicht 13 von einem zweiten Leitfähigkeitstyp (hier: n⁻-dotiert) angeordnet, wobei der zweite Leitfähigkeitstyp dem ersten entgegengesetzt ist. Die Emitterschicht 14 kann durch Anodenkurzschlussgebiete 15 des zweiten Leitfähigkeitstyps (hier: n⁺-dotiert) unterbrochen sein. Anodenseitig wird die Emitterschicht 14 von einem durchgehenden metallischen Anodenkontakt 16 kontaktiert.

Innerhalb des Halbleitersubstrats 1 sind weiterhin zwischen den beiden Hauptflächen H1 und H2 nebeneinander und abwechselnd eine Vielzahl von MCT-Zellen M und IGBT-Zellen I vorgesehen. Innerhalb jeder MCT-Zelle ist zwischen der ersten Basisschicht 13 und der ersten Hauptfläche H1 eine zweite, p-dotierte Basisschicht 12 angeordnet (hier und im Folgenden wird anstelle des abstrakten ersten und zweiten Leitfähigkeitstyp ohne Beschränkung der Allgemeinheit der Einfachheit halber nur noch die tatsächliche Dotierung des Ausführungsbeispiels genannt). In die zweite Basisschicht 12 ist von der ersten Hauptfläche her ein n⁺-dotiertes Emittergebiet 11 eingelassen ,welches auf der ersten Hauptfläche H1 von einem metallischen Kathodenkontakt 2 (z.B. aus Al) kontaktiert wird. Darüberhinaus ist kathodenseitig in an sich bekannter Weise eine erste MOS-Struktur vorgesehen, die aus der zweiten Basisschicht 12, einem n-dotierten ersten Kanalgebiet 9, einem darin eingelassenen, p⁺-dotierten Kathodenkurzschlussgebiet 7 und einer über dem ersten Kanalgebiet 9 isoliert angeordneten ersten Gateelektrode 3 (z.B. aus dotiertem PolySi) besteht. Die erste MOS-Struktur schliesst, wenn die erste Gateelektrode 3 auf negatives Potential gelegt wird, durch einen im ersten Kanalgebiet gebildeten p-Inversions-Kanal das Emittergebiet 11 kurz.

Innerhalb jeder IGBT-Zelle I ist von der ersten Hauptfläche H1 her in die erste Basisschicht 13 ein p⁺-dotiertes Kollektorgebiet 10 eingelassen, welches kathodenseitig durch eine zweite MOS-Struktur kurzgeschlossen werden kann, die aus der ersten Basisschicht 13, einem zweiten, p-dotierten Kanalgebiet 8, einem n⁺-dotierten Sourcegebiet 6 und einer über dem zweiten Kanalgebiet 8 isoliert angeordneten zweiten Gateelektrode 5 besteht.

Die beiden Gateelektroden 3 und 5 sind untereinander, vom Halbleitersubstrat 1 und vom Kathodenkontakt 2 durch eine Gateisolierung 4 (z.B. aus SiO₂) elektrisch getrennt und sind entsprechend durch getrennte Gateanschlüsse G1 und G2 von aussen unabhängig voneinander ansteuerbar. Die Funktion des Bauelements lässt sich wie folgt beschreiben: Wie beim MOS-ein- und ausschaltbaren MCT kann das neue Bauelement durch Anlegen einer positiven Spannung an MCT- und/oder IGBT-Gate (d.h. Gateanschluss G1 und/oder G2) gezündet werden. Bei entsprechender Auslegung kann das Gebiet der MCT-Zellen M so gestaltet werden, dass ohne Hilfe der IGBT-Zellen I gezündet werden kann (siehe z.B. die Fig. 2 aus der EP-A1-0 340 445). Im eingeschalteten Zustand wird der Strom zum grössten Teil von den MCT-Zellen getragen. Die Durchlassspannung ist also klein (im Bereich von etwa 3 V bei einer Stromdichte von 100 A/cm²). Wenn im eingeschalteten Zustand beide Gateanschlüsse G1 und G2 positiv vorgespannt sind, leiten sowohl die MCT- als auch die IGBT-Zellen.

Zum Abschalten werden die beiden Gateelektroden 3 und 5 zu unterschiedlichen Zeitpunkten auf negatives Potential gelegt. Als erstes werden alle MCT-Zellen M ausgeschaltet, indem der erste Gateanschluss G1 mit negativer Spannung betrieben wird. Das IGBT Gate (Gateanschluss G2) bleibt während dieser Phase noch auf positivem Potential, d.h. alle IGBT-Zellen sind noch eingeschaltet und leiten Strom. Durch das Anlegen der negativen Spannung an die MCT-Gates wird die Elektronenemission der Emittergebiete 11 nahezu augenblicklich (innerhalb einiger Picosekunden) unterbrochen. Bei induktiver Last fliesst der Anodenstrom in gleicher Höhe weiter. Da die IGBT-Zellen I noch leitend sind, verteilt sich der gesamte Strom auf diese Bereiche um. Die Anodenspannung steigt dabei auf einen Wert an, der entsprechend der IGBT-Charakteristik dem fliessenden Strom entspricht (die Anodenspannung liegt im Bereich von 9 V bei einer Stromdichte von 100 A/cm²). Daraus folgt, dass die MCT-Zellen M nur gegen eine verschwindend kleine Anodenspannung abschalten müssen, so dass selbst höchste Stromdichten problemlos abgeschaltet werden können. Probleme mit Lawinenerzeugung (avalanche) entstehen bei diesem Betrieb selbstverständlich nicht.

Kurze Zeit nach dieser Stromkommutierung von den MCT-Zellen M in die IGBT-Zellen I wird das IGBT-Gate (Gateanschluss G2) ebenfalls mit einer negativen Spannung beaufschlagt. Das Bauelement schaltet dann als reiner IGBT mit allen damit verbundenen Vorzügen ab. Die IGBT-Zellen I können dabei so ausgelegt werden, dass ein Abschaltfehler (durch latch-up) erst bei Stromdichten von weit über 1000 A/cm² auftritt. Aus dem Gesagten wird klar, dass das Abschalten der MCT-Zellen M nur eine Uebergangsphase ist; der eigentliche Abschaltvorgang mit dem Anstieg der Anodenspannung wird allein von den IGBT-Zellen I getragen. Es dürfte unter praktischen Bedingungen möglich und vorteilhaft sein, das IGBT-Gate bereits 500 ns bis 1 µs nach dem Schalten der MCT-Zellen negativ anzusteuern. Während dieser kurzen Verzögerungszeit schlagen die höheren Durchlassverluste der IGBTs kaum zu Buche.

Die Anordnung der MCT- und IGBT-Zellen M bzw. I im Bauelement kann vorteilhafterweise gemäss der Darstellung in Fig. 6 erfolgen: Von der Kathodenfläche, d.h. der Hauptfläche H1 her gesehen zeigt das Bauelement eine Fingerstruktur mit einer wechselnden Abfolge von MCT- und IGBT-Gebieten, die jeweils mit einem zugehörigen MCT- bzw. IGBT-Gatekontakt 19 bzw. 20 und entsprechenden Gateanschlüssen G1 und G2 in Verbindung stehen. Die gesamte Bauelementfläche kann etwa im Verhältnis 1:1 für IGBT-und MCT-Gebiet aufgeteilt werden. Es ist aber auch denkbar, den Flächenanteil der IGBT-Gebiete ohne grosse Schwierigkeiten auf etwa 20 % zu reduzieren. Eine sinnvolle Grösse für die einzelnen Gebiete bzw. Blöcke liegt dabei im Bereich von wenigen mm².

Obwohl auch bei anderen Bauelementen realisiert, ist die Kontaktierung von zwei Gateanschlüssen G1 und G2 auf einem Chip gemäss Fig. 5 bzw. 6 mit Nachteilen behaftet. Es wird deshalb ein Bauelement nach der Erfindung in Fig. 7 vorgeschlagen, bei der ein einziges Gatesignal zur Ansteuerung ausreicht, weil die notwendige zeitliche Verzögerung im Bauelement selbst generiert wird. Die beiden Gateelektroden 3 und 5 werden dazu durch ein Laufzeitglied verbunden. Es bleibt ein einziger Gateanschluss G, über den die erste Gateelektrode 3 direkt von aussen angesteuert werden kann.

Zur Realisierung des Laufzeitgliedes bietet sich die endliche Ausbreitungsgeschwindigkeit des Gatesignals in einer PolySi-Gateelektrode an. Zur Verbesserung der Leitfähigkeit sind die Gateelektroden 3 und 5 üblicherweise stark n- oder p-dotiert. Durch Einfügung eines hochohmigen Zwischengebietes 17 (hier wird das PolySi nicht dotiert, indem z.B. während der Implantation das entsprechende Gebiet durch einen Lack abgedeckt wird) zwischen den beiden Gateelektroden 3 und 5 kann nun mit einfachsten Mitteln und geringstem Platzaufwand ein geeignetes Laufzeitglied erzeugt werden, welches die erforderliche Signalverzögerung zwischen MCT- und IGBT-Abschaltsignal direkt auf dem Chip bewirkt.

Wenn - wie bereits weiter oben erwähnt - die MCT-Gebiete so ausgelegt werden, dass sie selbständig, also ohne Hilfe der IGBT-Zellen I einschalten (d.h. mittels Einschaltzellen innerhalb der MCT-Gebiete), tritt auch keine Verzögerung beim Einschalten auf. Selbst wenn die IGBT-Zellen das Einschalten übernehmen müssen, können Gatesignalverzögerungen bis zu einer µs toleriert werden, da der Einschaltvorgang selbst mindestens diese Zeitspanne benötigt. Insgesamt besitzt die in Fig. 7 dargestellte Variante des erfindungsgemässen Bauelements den Vorteil, mit einem "Bond-Pad" für das Gate auszukommen. Damit ist wertvoller Freiraum bei der internen Auslegung des Chip gewonnen.

Die Erfindung ist nicht auf die dargestellten Ausführungsbeispiele beschränkt. Selbstverständlich können anstelle der in Fig. 5 und 7 gezeigten Leitfähigkeitstypen auch die dazu komplementären vorgesehen werden, so dass z.B. eine n⁺-Dotierung durch eine p⁺-Dotierung ersetzt wird und umgekehrt. Weiterhin kann die Anodenseite ohne Anodenkurzschlüsse oder mit verschiedenen Arten von Anodenkurzschlüssen ausgeführt sein. Darüberhinaus ist es auch denkbar, zwischen der Emitterschicht 14 und der ersten Basisschicht 13 - wie in Fig. 7 angedeutet - zusätzliche eine n-dotierte Stoppschicht 18 anzuordnen, oder aber eine p⁻-dotierte Sperrschicht 21, wie dies in der EP-A1-0 327 901 für GTOs bereits vorgeschlagen worden ist. Schliesslich können die einzelnen Zellen M bzw. I in lateraler Richtung quadratisch, rechteckig, sechseckig oder auch streifenförmig ausgebildet sein.

Insgesamt ergibt sich mit der Erfindung ein Bauelement und ein Verfahren zu dessen Betrieb, welche die Vorteile eines IGBT und MCT gleichermassen in sich vereinen und den MOS-kontrollierten Bauelementen neue Leistungsbereiche erschliessen.

### BEZEICHNUNGSLISTE

- 1: Halbleitersubstrat
- 2: Kathodenkontakt
- 3,5: Gateelektrode
- 4: Gateisolierung
- 6: Sourcegebiet
- 7: Kathodenkurzschlussgebiet
- 8,9: Kanalgebiet
- 10: Kollektorgebiet
- 11: Emittergebiet
- 12,13: Basisschicht
- 14: Emitterschicht
- 15: Anodenkurzschlussgebiet
- 16: Anodenkontakt
- 17: Zwischengebiet
- 18: Stoppschicht
- 19: MCT-Gatekontakt
- 20: IGBT-Gatekontakt
- 21: Sperrschicht
- A: Anode
- G,G1,G2: Gateanschluss
- H1,H2: Hauptfläche
- I: IGBT-Zelle
- Iₐ: Anodenstrom
- I_{C}: Kollektorstrom
- K: Kathode
- M: MCT-Zelle
- Vₐ: Anodenspannung
- V_{CE}: Kollektor-Emitter-Spannung
- V_{G}: Gatespannung

## Patentansprüche

1. Abschaltbares Leistungshalbleiter-Bauelement, umfassend
(a) ein Halbleitersubstrat (1) mit zwei gegenüberliegenden Hauptflächen (H1,H2), von denen die erste (H1) einer Kathode (K) zugeordnet ist und eine Kathodenfläche bildet, und die zweite (H2) einer Anode (A) zugeordnet ist;
(b) innerhalb des Halbleitersubstrats (1) zwischen den beiden Hauptflächen (H1,H2) von der Anode (A) her eine Schichtenfolge mit einer Emitterschicht (14) von einem ersten Leitfähigkeitstyp und einer ersten Basisschicht (13) von einem zweiten, dem ersten entgegengesetzten Leitfähigkeitstyp;
(c) innerhalb des Halbleitersubstrats (1) zwischen den beiden Hauptflächen (H1,H2) eine Vielzahl von nebeneinander angeordneten und parallel geschalteten MCT-Zellen (M) und IGBT-Zellen (I);
(d) innerhalb jeder MCT-Zelle (M)
(aa) zwischen der ersten Basisschicht (13) und der ersten Hauptfläche (H1) eine zweite Basisschicht (12) vom ersten Leitfähigkeitstyp;
(bb) ein von der ersten Hauptfläche (H1) her in die zweite Basisschicht (12) eingelassenes Emittergebiet (11) vom zweiten Leitfähigkeitstyp, welches durch einen auf die erste Hauptfläche (H1) aufgebrachten Kathodenkontakt (2) kontaktiert ist; und
(cc) auf der Kathodenseite eine mittels einer isolierten ersten Gateelektrode (3) steuerbare erste MOS-Struktur, welche einen schaltbaren Kurzschluss zwischen der zweiten Basisschicht (12) und dem Kathodenkontakt (2) bildet; und
(e) innerhalb jeder IGBT-Zelle (I)
(aa) ein von der ersten Hauptfläche (H1) her in die erste Basisschicht (13) eingelassenes Kollektorgebiet vom ersten Leitfähigkeitstyp, welches durch den Kathodenkontakt (2) auf der ersten Hauptfläche (H1) kontaktiert ist; und
(bb) auf der Kathodenseite eine mittels einer isolierten zweiten Gateelektrode (5) steuerbare zweite MOS-Struktur, welche einen schaltbaren Kurzschluss zwischen der ersten Basisschicht (13) und dem Kathodenkontakt (2) bildet; wobei
(f) die erste und die zweite Gateelektrode (3 bzw. 5) als separate Gateelektroden ausgebildet sind;
dadurch gekennzeichnet, dass
(g) die erste Gateelektrode (3) einen eigenen Gateanschluss (G) aufweist und die zweite Gateelektrode (5) mit der ersten Gateelektrode (3) durch ein Laufzeitglied in Verbindung steht, durch welches ein an dem Gateanschluss (G) anliegendes Gatesignal mit zeitlicher Verzögerung auf die zweite Gateelektrode (5) gelangt.

2. Bauelement nach Anspruch 1, dadurch gekennzeichnet, dass das Laufzeitglied zwischen den beiden Gateelektroden (3 bzw. 5) durch ein hochohmiges Zwischengebiet (17), insbesondere in Form einer undotierten Poly-Silizium-Schicht, gebildet wird.

3. Bauelement nach einem der Ansprüche 1 bis 2, dadurch gekennzeichnet, dass die Gebiete der MCT-Zellen (M) und IGBT-Zellen (I) lateral als ineinandergreifende Fingerstrukturen ausgebildet sind.

4. Bauelement nach einem der Ansprüche 1 bis 3, dadurch gekennzeichnet, dass
(a) die erste MOS-Struktur aus der zweiten Basisschicht (12), einem ersten Kanalgebiet (9) vom zweiten Leitfähigkeitstyp, einem Kathodenkurzschlussgebiet (7) vom ersten Leitfähigkeitstyp und von der über dem ersten Kanalgebiet (9) angeordneten ersten Gateelektrode (3) gebildet wird; und
(b) die zweite MOS-Struktur aus der ersten Basisschicht (13), einem zweiten Kanalgebiet (8) vom ersten Leitfähigkeitstyp, einem Sourcegebiet (6) vom zweiten Leitfähigkeitstyp und von der über dem zweiten Kanalgebiet (8) angeordneten zweiten Gateelektrode (5) gebildet wird.

5. Bauelement nach einem der Ansprüche 1 bis 4, dadurch gekennzeichnet, dass die Emitterschicht (14) von Anodenkurzschlussgebieten (15) des zweiten Leitfähigkeitstyps durchbrochen ist.

6. Bauelement nach einem der Ansprüche 1 bis 5, dadurch gekennzeichnet, dass zwischen der Emitterschicht (14) und der ersten Basisschicht (13) eine Stoppschicht (18) vom zweiten Leitfähigkeitstyp angeordnet ist.

7. Bauelement nach einem der Ansprüche 1 bis 6, dadurch gekennzeichnet, dass zwischen der Emitterschicht (14) und der ersten Basisschicht (13) eine schwach dotierte Sperrschicht (21) vom ersten Leitfähigkeitstyp angeordnet ist.

8. Bauelement nach einem der Ansprüche 1 bis 7, dadurch gekennzeichnet, dass die Emitterschicht (14) p⁺-do-tiert, die erste Basisschicht (13) n⁻-dotiert, die zweite Basisschicht (12) p-dotiert, die Emittergebiete (11) n⁺-dotiert und die Kollektorgebiete (10) p⁺-dotiert sind.

## Claims

1. Turn-off power semiconductor component, comprising
(a) a semiconductor substrate (1) having two opposing main areas (H1, H2), of which the first (H1) is assigned to a cathode (K) and forms a cathode area, and the second (H2) is assigned to an anode (A);
(b) within the semiconductor substrate (1) between the two main areas (H1, H2), from the anode (A), a layer sequence with an emitter layer (14) of a first conductivity type and a first base layer (13) of a second conductivity type opposite to the first;
(c) within the semiconductor substrate (1) between the two main areas (H1, H2), a multiplicity of MCT cells (M) and IGBT cells (I) arranged next to one another and connected in parallel;
(d) within each MCT cell (M)
(aa) a second base layer (12) of the first conductivity type between the first base layer (13) and the first main area (H1);
(bb) an emitter region (11) of the second conductivity type, which emitter region is let into the second base layer (12) from the first main area (H1) and is made contact with by a cathode contact (2) applied to the first main area (H1); and
(cc) on the cathode side, a first MOS structure which can be controlled by means of an insulated first gate electrode (3) and forms a switchable short circuit between the second base layer (12) and the cathode contact (2); and
(e) within each IGBT cell (I)
(aa) a collector region of the first conductivity type, which collector region is let into the first base layer (13) from the first main area (H1) and is made contact with by the cathode contact (2) on the first main area (H1); and
(bb) on the cathode side, a second MOS structure which can be controlled by means of an insulated second gate electrode (5) and forms a switchable short circuit between the first base layer (13) and the cathode contact (2);
(f) the first and the second gate electrode (3 and 5, respectively) being designed as separate gate electrodes;
characterized in that
(g) the first gate electrode (3) has a dedicated gate terminal (G) and the second gate electrode (5) is connected to the first gate electrode (3) by a delay element, by means of which a gate signal applied to the gate terminal (G) passes with a time delay to the second gate electrode (5).

2. Component according to Claim 1, characterized in that the delay element between the two gate electrodes (3 and 5) is formed by a high-impedance intermediate region (17), in particular in the form of an undoped polysilicon layer.

3. Component according to either of Claims 1 and 2, characterized in that the regions of the MCT cells (M) and IGBT cells (I) are designed laterally as meshing finger structures.

4. Component according to one of Claims 1 to 3,
characterized in that
(a) the first MOS structure is formed by the second base layer (12), a first channel region (9) of the second conductivity type, a cathode short-circuit region (7) of the first conductivity type and the first gate electrode (3) arranged over the first channel region (9); and
(b) the second MOS structure is formed by the first base layer (13), a second channel region (8) of the first conductivity type, a source region (6) of the second conductivity type and the second gate electrode (5) arranged over the second channel region (8).

5. Component according to one of Claims 1 to 4, characterized in that the emitter layer (14) is broken by anode short-circuit regions (15) of the second conductivity type.

6. Component according to one of Claims 1 to 5, characterized in that a stop layer (18) of the second conductivity type is arranged between the emitter layer (14) and the first base layer (13).

7. Component according to one of Claims 1 to 6, characterized in that a weakly doped depletion layer (21) of the first conductivity type is arranged between the emitter layer (14) and the first base layer (13).

8. Component according to one of Claims 1 to 7, characterized in that the emitter layer (14) is p⁺-doped, the first base layer (13) is n⁻-doped, the second base layer (12) is p-doped, the emitter regions (11) are n⁺-doped and the collector regions (10) are p⁺-doped.

## Revendications

1. Composant semi-conducteur de puissance à extinction, comprenant
(a) un substrat semi-conducteur (1) avec deux surfaces principales (H1, H2) opposées, dont la première (H1) est attribuée à une cathode (K) et qui forme une surface de cathode et dont la seconde (H2) est attribuée à une anode (A);
(b) à l'intérieur du substrat semi-conducteur (1), entre les deux surfaces principales (H1, H2), à partir de l'anode (A) une suite de couches comportant une couche émetteur (14) constituée d'un premier type de porteurs et une première couche de base (13) constituée d'un second type de porteurs opposé au premier ;
(c) à l'intérieur du substrat semi-conducteur (1), entre les deux surfaces principales (H1, H2), une multiplicité de cellules MCT (M) et IGBT (I) disposées l'une à côté de l'autre et branchées en parallèle
(d) à l'intérieur de chaque cellule MCT (M)
(aa) entre la première couche de base (13) et la première surface principale (H1), une seconde couche de base (12) constituée du premier type de porteurs ;
(bb) à partir de la première surface principale (H1), enterrée dans la seconde couche de base (12), une zone émetteur (11) constituée du second type de porteurs, qui est connectée au moyen d'un contact de cathode (2) appliqué sur la première surface principale (H1) ; et
(cc) du côté de la cathode une première structure MOS pouvant être commandée au moyen d'une première-électrode de grille isolée (3), qui forme un court-circuit commutable entre la seconde couche de base (12) et le contact de cathode (2) ; et
(e) à l'intérieur de chaque cellule IGBT (I)
(aa) à partir de la première surface principale (H1), enterrée dans la première couche de base (13), une zone collecteur constituée du premier type de porteurs, qui est connectée au moyen du contact de cathode (2) à la première surface principale (H1) ; et
(bb) du côté de la cathode on trouve une seconde structure MOS pouvant être commandée au moyen d'une seconde électrode de grille isolée (5), qui forme un court-circuit commutable entre la première couche de base (13) et le contact de cathode (2) ;
(f) la première et la seconde électrode de grille (respectivement 3 et 5) étant formées en électrodes de grille séparées ;
caractérisée en ce que
(g) la première électrode de grille (3) présente un raccordement de grille (G) et la seconde électrode de grille (5) est en liaison avec la première électrode de grille (3) au moyen d'un élément de délai à l'aide duquel un signal de grille, adjacent au raccordement de grille (G), arrive avec retard sur la seconde électrode de grille (5).

2. Composant selon la revendication 1, caractérisé en ce que l'élément de délai est formé entre les deux électrodes de grille (respectivement 3 et 5) au moyen d'une zone intermédiaire de forte résistance ohmique (17), en particulier sous forme d'une couche de polysilicium non dopée.

3. Composant selon l'une des revendications 1 à 2, caractérisé en ce que les zones des cellules MCT (M) et des cellules IGBT (I) sont formées latéralement en structures de peignes imbriquées l'une dans l'autre.

4. Composant selon l'une des revendications 1 à 3,
caractérisé en ce que
(a) la première structure MOS est formée par la seconde couche de base (12), une première zone de canal (9) constituée du second type de porteurs, une zone de court-circuit de cathode (7) constituée du premier type de porteurs, et de la première électrode de grille (3) disposée au-dessus de la première zone de canal (9); et
(b) la seconde structure MOS est formée par la première couche de base (13), une seconde zone de canal (8) constituée du premier type de porteurs, une zone de source (6) constituée du second type de porteurs, et de la seconde électrode de grille (5) disposée au-dessus de la seconde zone de canal (8).

5. Composant selon l'une des revendications 1 à 4, caractérisé en ce que la couche d'émetteur (14) est traversée par des zones de court-circuit d'anode (15) constituées du second type de porteurs.

6. Composant selon l'une des revendications 1 à 5, caractérisé en ce qu'une couche d'arrêt (18) constituée du second type de porteurs est disposée entre la couche d'émetteur (14) et la première couche de base (13).

7. Composant selon l'une des revendications 1 à 6, caractérisé en ce qu'une couche de blocage faiblement dopée (21) constituée du premier type de porteurs est disposée entre la couche d'émetteur (14) et la première couche de base (13).

8. Composant selon l'une des revendications 1 à 7, caractérisé en ce que la couche d'émetteur (14) est dopée p⁺, la première couche de base (13) est dopée n⁻, la seconde couche de base (12) est dopée p⁻, les zones d'émetteur (11) sont dopées n⁺ et les zones de collecteur (10) sont dopées p⁺.
